# EUROPEAN PATENT APPLICATION

(11) **EP 4 793 704 A1**
(43) Date of publication of application: **19.08.2026**
(21) Application number: 25200163.1
(22) Date of filing: 04.09.2025
(51) Int. Cl.: G03F 1/24, G03F 1/38, G03F 7/00

(54) **PHOTOMASK AND EXPOSURE METHOD**

(30) Priority: 17.02.2025 JP 2025023041
(71) Applicant: Kioxia Corporation, Tokyo 108-0023 (JP)
(72) Inventor: KIMPARA, Suzuka, 108-0023 Minato-ku, Tokyo (JP); ABE, Satomi, 108-0023 Minato-ku, Tokyo (JP); MATSUNAGA, Kentaro, 108-0023 Minato-ku, Tokyo (JP)
(74) Representative: Hoffmann Eitle

(57) **Abstract**

A photomask (10, 10b) according to an embodiment is a photomask (10, 10b) including a stitching area (ST, STa, STb) having a first end portion (E32) at one end portion (E12) of the photomask (10, 10b) and having a second end portion (E31) at a position located inward from the one end portion (E12) by a predetermined distance, the photomask (10, 10b) includes a substrate (12), a reflective layer (13, 13b) that is arranged on a first surface of the substrate (12), the reflective layer (13, 13b) configured to reflect light, and a light-shielding pattern (P1, P2, P3) that is arranged on a second surface of the reflective layer (13, 13b) opposite to the substrate (12) and that includes a light-absorbing layer (15) configured to absorb the light, in which in the stitching area (ST, STa, STb), a reflection intensity of the light is lower on a side of the first end portion (E32) than on a side of the second end portion (E31).

## Description

### CROSS-REFERENCE TO RELATED APPLICATIONS

This application is based upon and claims the benefit of priority from Japanese Patent Application No. 2025-023041, filed on February 17, 2025; the entire contents of which are incorporated herein by reference.

### FIELD

Embodiments described herein relate generally to a photomask and an exposure method.

### BACKGROUND

In high-numerical aperture extreme ultra-violet (High-NA EUV) exposure, a mask has a mask magnification of, for example, 4×8 times with respect to a pattern transferred onto a wafer. Meanwhile, the photomask itself is maintained in a size on the premise that the photomask has a mask magnification of, for example, 4×4 times.

### BRIEF DESCRIPTION OF THE DRAWINGS

Figs. 1A to 1C are schematic diagrams each illustrating an exemplary configuration of a photomask according to a first embodiment;
Figs. 2A to 2G are schematic diagrams illustrating exemplary configurations of light-shielding patterns provided on a surface of the photomask according to the first embodiment facing a wafer;
Figs. 3A and 3B are cross-sectional views sequentially illustrating a part of a procedure of an exposure method using the photomask according to the first embodiment;
Figs. 4A and 4B are cross-sectional views sequentially illustrating a part of a procedure of the exposure method using the photomask according to the first embodiment;
Figs. 5A to 5D are cross-sectional views each illustrating a part of a procedure of a processing method for the wafer according to the first embodiment;
Figs. 6A to 6D are schematic diagrams illustrating exemplary configurations of a light-shielding pattern provided on a surface of a photomask according to a first modification of the first embodiment facing the wafer;
Figs. 7A to 7C are schematic diagrams each illustrating an exemplary configuration of a photomask according to a second modification of the first embodiment;
Figs. 8A and 8B are schematic diagrams each illustrating an exemplary configuration of a photomask according to a second embodiment;
Figs. 9A to 9E are cross-sectional views sequentially illustrating a part of a method of manufacturing a pellicle according to the second embodiment;
Figs. 10A to 10F are cross-sectional views sequentially illustrating a part of the method of manufacturing a pellicle according to the second embodiment;
Figs. 11A and 11B are cross-sectional views sequentially illustrating a part of a method of manufacturing a pellicle according to a first modification of the second embodiment;
Fig. 12 is a cross-sectional view sequentially illustrating a part of the method of manufacturing a pellicle according to the first modification of the second embodiment;
Figs. 13A to 13C are cross-sectional views sequentially illustrating a part of the method of manufacturing a pellicle according to the first modification of the second embodiment;
Figs. 14A and 14B are cross-sectional views sequentially illustrating a part of the method of manufacturing a pellicle according to the first modification of the second embodiment;
Fig. 15 is a cross-sectional view sequentially illustrating a part of the method of manufacturing a pellicle according to the first modification of the second embodiment;
Figs. 16A to 16C are cross-sectional views illustrating part of a method of manufacturing a pellicle according to a second modification of the second embodiment;
Figs. 17A to 17C are cross-sectional views sequentially illustrating a part of a method of manufacturing a pellicle according to a third modification of the second embodiment;
Figs. 18A to 18C are cross-sectional views sequentially illustrating a part of the method of manufacturing a pellicle according to the third modification of the second embodiment;
Figs. 19A and 19B are cross-sectional views sequentially illustrating a part of the method of manufacturing a pellicle according to the third modification of the second embodiment; and
Figs. 20A and 20B are schematic diagrams each illustrating an exemplary configuration of a photomask according to a fourth modification of the second embodiment.

### DETAILED DESCRIPTION

A photomask according to an embodiment is a photomask including a stitching area having a first end portion at one end portion of the photomask and having a second end portion at a position located inward from the one end portion by a predetermined distance, the photomask includes a substrate, a reflective layer that is arranged on a first surface of the substrate, the reflective layer configured to reflect light, and a light-shielding pattern that is arranged on a second surface of the reflective layer opposite to the substrate and that includes a light-absorbing layer configured to absorb the light, in which in the stitching area, a reflection intensity of the light is lower on a side of the first end portion than on a side of the second end portion.

Embodiments of the present invention will be described in detail below with reference to the drawings. Note that the present invention is not limited to the following embodiments. Furthermore, component elements in the following embodiments include component elements that are readily conceivable by a person skilled in the art or that are substantially equivalent.

### [First Embodiment]

Hereinafter, a first embodiment will be described in detail with reference to the drawings.

### (Exemplary configuration of photomask)

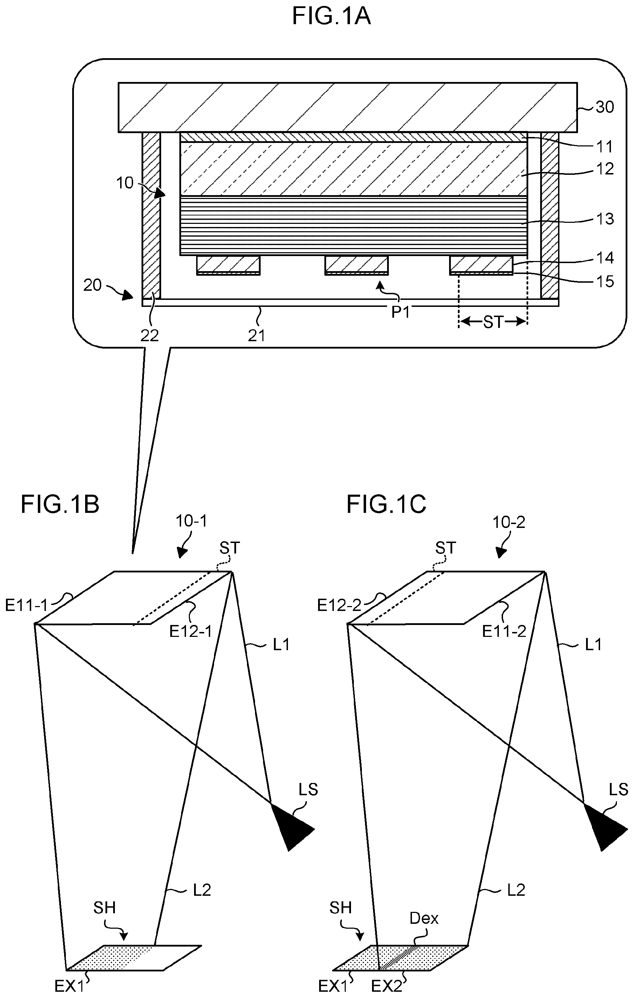

Figs. 1A to 1C are schematic diagrams each illustrating an exemplary configuration of a photomask 10 according to the first embodiment. More specifically, Fig. 1A is a cross-sectional view of the photomask 10 with a pellicle 20 mounted thereon, and Figs. 1B and 1C are schematic diagrams each illustrating an overview of an exposure method using the photomask 10.

Note that in the following description, unless otherwise specified, even a simple description such as photomask 10 refers to the photomask 10 with the pellicle 20 mounted, which will be described in detail below.

The photomask 10 of the first embodiment is configured as a reflective photomask used for, for example, high NA-EUV exposure.

The high NA-EUV exposure is a technique of exposure with extreme ultraviolet light (EUV) of 13.5 nm by using, for example, a lens whose numerical aperture (NA) is expanded from the conventional 0.33 to 0.55. NA is a physical quantity indicating performance of a lens that enables concentrate and narrow light, and it is possible to form a finer pattern by using a high-NA lens.

Furthermore, in the high NA-EUV exposure, a mask magnification that has been, for example, 4×4 times is enlarged to 4×8 times with respect to the pattern transferred onto a wafer. Therefore, in order to maintain a conventional mask size, for example, a pair of two photomasks 10 (10-1 and 10-2) is used to expose one shot area on the wafer. A process of the exposure is illustrated in Figs. 1B and 1C.

As illustrated in Fig. 1B, the photomask 10-1 that is one of the pair of photomasks 10 (10-1 and 10-2) is used to expose an area approximately half of a shot area SH provided on the wafer.

Each of the photomasks 10 of the first embodiment is, for example, a reflective photomask as described above, and irradiates the shot area SH with light L2 obtained by reflecting light L1 such as EUV emitted from a light source LS. Although not illustrated in the drawing, each of the light L1 and the light L2 reaches the photomask 10 or the shot area SH on the wafer, which is an arrival target, via a plurality of reflectors.

As illustrated in Fig. 1C, the photomask 10-2 which is the other of the pair of photomasks 10 (10-1 and 10-2) is used to expose a remaining area approximately half of the shot area SH provided on the wafer.

Here, an exposed area EX1 exposed by the photomask 10-1 and an exposed area EX2 exposed by the photomask 10-2 partially overlap each other near the center of the shot area SH. Therefore, the overlapping area, that is, an exposed area Dex is subjected to double exposure, and therefore, it is preferable to perform some adjustment so as not to cause excessive light intensity due to the double exposure. This is because the excessive light intensity has a possibility of an increased critical dimension loss, such as thinning of a transferred pattern to the wafer in the exposed area Dex.

Therefore, the photomasks 10 are each provided with a stitching area ST corresponding to the exposed area Dex to adjust the excessive light intensity in the exposed area Dex is adjusted.

More specifically, the photomask 10-1 is provided with the stitching area ST at an end portion E12-1 on the right side of the drawing at a position corresponding to the vicinity of the center of the shot area SH, from among an end portion E11-1 and the end portion E12-1 on both sides of the left and right sides of the drawing, and the photomask 10-2 is provided with the stitching area ST at an end portion E12-2 on the left side of the drawing at a position corresponding to the vicinity of the center of the shot area SH, from among the end portion E12-2 and an end portion E11-2 on both sides of the left and right sides of the drawing.

In these stitching areas ST, the transferred patterns and the like extending over the exposed areas EX1 and EX2 of the two photomasks 10 are connected to be aligned with each other in the shot area SH.

As illustrated in Fig. 1A, the pair of the photomasks 10 may have a common basic configuration.

Each of the photomasks 10 includes a glass substrate 12 that has one surface covered with a conductive layer 11, and is held by an electrostatic chuck 30 or the like of an exposure apparatus via the conductive layer 11 with the other surface of the glass substrate 12 facing toward the wafer. The glass substrate 12 is made of, for example, low-thermal-expansion substrate material (LTEM).

Furthermore, the photomask 10 includes a reflective layer 13, a buffer layer 14, and a light-absorbing layer 15 on a surface of the glass substrate 12 facing the wafer, in order from the glass substrate 12.

The reflective layer 13 has, for example, a multilayer structure in which a plurality of Mo layers and a plurality of Si layers are alternately stacked one by one. Therefore, a diffraction phenomenon of light such as exposure light incident on the reflective layer 13 at a predetermined angle is caused, and the light is reflected at an angle corresponding to the incident angle. It is difficult to reflect extremely short wavelength light such as EUV by an optical mirror or the like, and therefore, the light is reflected by using such an artificial lattice structure.

The buffer layer 14 is, for example, a Ru layer or the like, and serves as a base layer of the light-absorbing layer 15. The light-absorbing layer 15 is, for example, a TaBN layer or the like, and has a property of absorbing exposure light such as EUV. In addition, the light-absorbing layer 15 constitutes a light-shielding pattern P1 having a predetermined pattern thereon, together with the buffer layer 14, and is dispersedly arranged on the reflective layer 13.

The light L1 from the light source LS is absorbed by the light-absorbing layer 15 included in the light-shielding pattern P1, and the remaining light L2 is reflected toward the wafer by the reflective layer 13 exposed from the light-shielding pattern P1, whereby the light-shielding pattern P1 is transferred to the shot area SH of the wafer.

Note that, as will be described later, the photomask 10 has a light-shielding pattern that is not transferred to the wafer in the stitching area ST.

The pellicle 20 includes, for example, a protective layer 21 and a frame 22 and protects a surface of the photomask 10 on which the light-shielding pattern P1 and the like are arranged.

The protective layer 21 is, for example, a carbon-based layer of carbon nanotube, graphene, or the like, a plastic layer of polyimide or the like, or an inorganic layer of polysilicon, silicon carbide, or the like. When the protective layer 21 is the carbon-based layer, the protective layer is preferably made of a material having a carbon content of 40 mass% or more. As a result, the protective layer 21 has high transmittance to exposure light such as EUV, enabling covering and protection of the surface of the photomask 10 almost without hindering incidence of the light L1 from the light source LS to the photomask 10 and emission of the light L2 reflected from the photomask 10.

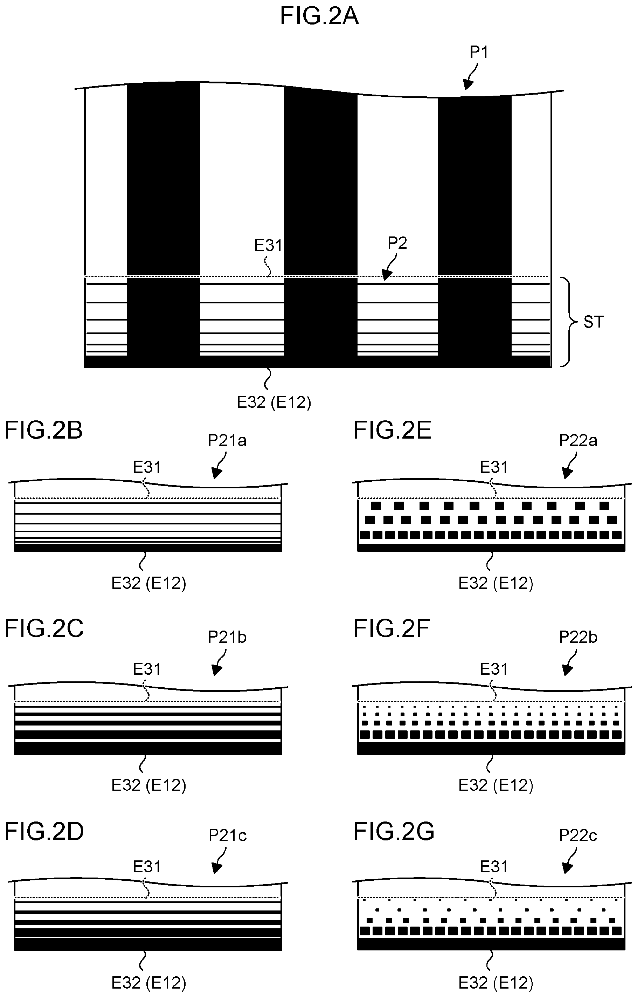

The frame 22 is made of, for example, an aluminum alloy, and supports the protective layer 21. In the example of Fig. 2A, the frame 22 is held by the electrostatic chuck 30 of the exposure apparatus together with the photomask 10, but the frame 22 may have a lower end portion that is directly held on the surface of the photomask 10 with an adhesive or the like.

The pellicle 20 may have an oxidation-inhibiting layer, which is not illustrated, or the like that inhibits oxidation of the protective layer 21 on a side of the protective layer 21 facing the wafer. In this configuration, for the oxidation-inhibiting layer, for example, a SiO₂ layer, a SiN layer, or the like can be used.

In addition, the protective layer 21 alone or the protective layer 21 provided with the oxidation-inhibiting layer, which is not mounted to the frame 22, may be used as the pellicle.

For example, the photomask 10 having the above configuration can be manufactured as follows.

The reflective layer 13 is formed by alternately stacking the Mo layers and the Si layers one by one on the glass substrate 12 by chemical vapor deposition (CVD), sputtering, or the like. In addition, the buffer layer 14 and the light-absorbing layer 15 are formed in this order on the reflective layer 13 by CVD, sputtering, or the like, and processed into a pattern shape including the light-shielding pattern P1 by reactive ion etching (RIE) or the like. In addition, the conductive layer 11 is formed on a back surface of the glass substrate 12 by CVD, sputtering, or the like.

As described above, the photomask 10 of the first embodiment is manufactured.

For example, the pellicle 20 having the above configuration can be manufactured as follows.

The protective layer 21 is formed on a support substrate by using CVD or the like. When the protective layer 21 is a plastic layer, it is also possible to form the protective layer 21 by immersing the support substrate in a dispersion liquid in which a resin material to be a material of the protective layer 21 is dispersed. In addition, the oxidation-inhibiting layer covering the protective layer 21 may be further formed by CVD or the like. Thereafter, the protective layer 21 is applied to the frame 22.

As described above, the pellicle 20 of the first embodiment is manufactured.

Figs. 2A to 2G are schematic diagrams illustrating exemplary configurations of light-shielding patterns P1 and P2 provided on a surface of each photomask 10 according to the first embodiment facing the wafer. More specifically, Fig. 2A is a plan view illustrating an exemplary configuration of the light-shielding patterns P1 and P2, and Figs. 2B to 2G are plan views illustrating some exemplary configurations of the light-shielding patterns P2.

As illustrated in Fig. 2A, the light-shielding pattern P1 is provided over substantially the entire area of the surface of the photomask 10 facing the wafer including the stitching area ST. The light-shielding pattern P1 is a pattern transferred to the wafer as described above, and a pattern based on a design pattern can be appropriately selected from various patterns such as a line-and-space pattern, a dot pattern, and a hole pattern.

Similarly to the light-shielding pattern P1, the light-shielding pattern P2 is a pattern including the light-absorbing layer 15 and the buffer layer 14 provided on the reflective layer 13. However, while the light-shielding pattern P1 is transferred to the wafer in combination with the reflective layer 13, the light-shielding pattern P2 is not transferred to the wafer as described above. The light-shielding pattern P2 may be, for example, a sub-resolution assist feature (SRAF) pattern.

More specifically, the light-shielding pattern P2 is arranged in the stitching area ST and is configured to have a coverage increasing stepwise from an end portion E31 that is one end portion of the stitching area ST toward an end portion E32 that is the other end portion of the stitching area ST.

Here, the end portion E31 of the stitching area ST is an end portion closer to the center of the photomask 10. Furthermore, the end portion E32 of the stitching area ST is located at an end portion E12 on one side of the photomask 10. In other words, the end portion E32 of the stitching area ST matches the end portion E12 on the one side of the photomask 10.

Some examples of the light-shielding pattern P2 whose coverage varies in this manner are illustrated in Figs. 2B to 2G.

In the example illustrated in Figs. 2B to 2D, light-shielding patterns P21a to P21c as the light-shielding pattern P2 each have a line-and-space pattern.

As illustrated in Fig. 2B, the light-shielding pattern P21a is configured by combining lines having a constant width and spaces whose width decreases toward the end portion E32 of the stitching area ST.

As illustrated in Fig. 2C, the light-shielding pattern P21b is configured by combining lines whose width increases toward the end portion E32 of the stitching area ST and spaces having a constant width.

As illustrated in Fig. 2D, the light-shielding pattern P21c includes lines whose width increases toward the end portion E32 of the stitching area ST and spaces whose width decreases toward the end portion E32 of the stitching area ST.

In the example illustrated in Figs. 2E to 2G, light-shielding patterns P22a to P22c as the light-shielding pattern P2 each have a dot pattern.

As illustrated in Fig. 2E, the light-shielding pattern 22a includes dots each having a constant area, and these dots are arranged so that pitches decrease toward the end portion E32 of the stitching area ST.

As illustrated in Fig. 2F, the light-shielding pattern 22b includes a plurality of dots having different areas, and these dots are arranged so that areas increase toward the end portion E32 of the stitching area ST.

As illustrated in Fig. 2G, the light-shielding pattern 22c includes a plurality of dots having different areas, and these dots are arranged so that areas increase and pitches decrease toward the end portion E32 of the stitching area ST.

in this way, the light-shielding pattern P2 is configured by combining a predetermined pattern such as a line-and-space pattern or a dot pattern, and any one or both of the arrangement density (pitch) and the size (width and area) of these patterns are changed to constitute the light-shielding pattern P2 so that the coverage increases stepwise from the end portion E31 to the end portion E32 of the stitching area ST.

Constituting the light-shielding pattern P2 so that the coverage changes in this way in the stitching area ST reduces the light intensity of the exposure light reflected from the photomask 10 to the wafer per unit area toward the end portion E12 on the one side of the photomask 10. Therefore, it is possible to suppress the excessive light intensity due to the double exposure in the overlapping portion of the exposed areas EX1 and EX2 (see Figs. 1B and 1C) of the pair of two photomasks 10, that is, in the exposed area Dex.

With a configuration as described above, the stitching area ST included in the photomask 10 of the first embodiment has a function of adjusting the light-shielding pattern P1 and the like transferred to the exposed areas EX1 and EX2 to be aligned with each other in the shot area SH.

Note that in the above example, although the light-shielding pattern P2 having the line-and-space pattern or the dot pattern has been described, but the light-shielding pattern P2 is not limited to these patterns. Any pattern, such as a combination of the line-and-space pattern and the dot pattern or another pattern, can be adopted as long as the reflection intensity in the photomask 10 per unit area can be adjusted.

Furthermore, the pair of photomasks 10 (10-1 and 10-2) has a common basic configuration, for example, as described above. However, this basic configuration does not mean that the pair of photomasks 10 have the same light-shielding patterns P1 and the same light-shielding patterns P2.

The light-shielding pattern P1 may have different light-shielding patterns P1, for example, one of the pair of photomasks 10 has the light-shielding pattern P1 corresponding to an element pattern and the other has the light-shielding pattern P1 corresponding to a peripheral circuit pattern, according to the positions in the shot area SH (see Figs. 1B and 1C) of the wafer to which the photomasks 10 correspond. Meanwhile, when a repetitive pattern occupies most of the shot area SH like a large-capacity cell array, the pair of photomasks 10 may have the light-shielding patterns P1 equal to each other.

Furthermore, for the light-shielding pattern P2, light-shielding patterns P2 having any shape and arrangement can be adopted for the pair of photomasks 10, and the photomasks 10 may be configured to have the light-shielding patterns P2 equal to each other or may be configured to have different light-shielding patterns P2.

### (Pattern forming method)

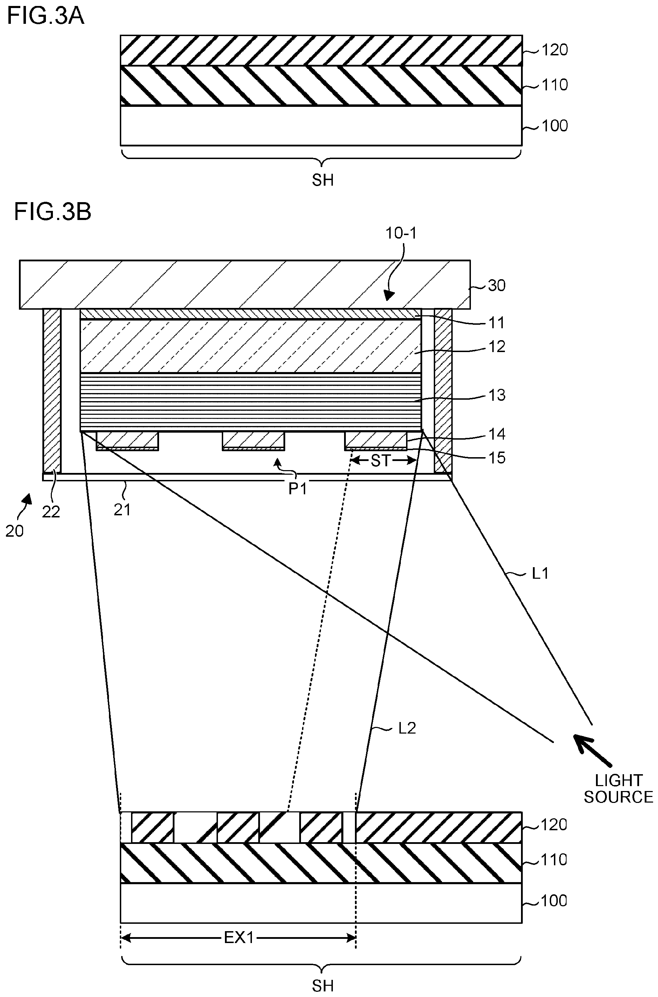

Next, a pattern forming method including the exposure method using the photomasks 10 of the first embodiment will be described with reference to Figs. 3A to 5D.

Figs. 3A to 4B are cross-sectional views sequentially illustrating a part of a procedure of the exposure method using the photomasks 10 according to the first embodiment.

As illustrated in Fig. 3A, a wafer 100 on which a processed layer 110 and a photoresist layer 120 are formed in this order is prepared.

The wafer 100 is, for example, a semiconductor substrate such as a silicon wafer. The processed layer 110 is a layer to be processed into a shape of the light-shielding pattern P1 or the like, and may be an insulating layer such as an SiO₂ layer or an SiN layer, a semiconductor layer such as a polysilicon layer, a metal layer such as a tungsten layer, or the like. In the examples of Figs. 3A to 5D, the processed layer 110 is the insulating layer such as the SiO₂ layer. The photoresist layer 120 is a layer to be exposed using each photomask 10 and serves as a mask when processing the processed layer 110.

Note that it is assumed that the wafer 100 is partitioned into a plurality of the shot areas SH.

As illustrated in Fig. 3B, one (e.g., the photomask 10-1) of the pair of photomasks 10 is mounted on the electrostatic chuck 30 of the exposure apparatus, and is arranged at a predetermined position where the photomask faces the wafer 100 conveyed into the exposure apparatus. The light L1 such as EUV emitted from the light source LS (see Figs. 1B and 1C) of the exposure apparatus is reflected by the photomask 10, and the reflected light L2 is applied to the photoresist layer 120 of a predetermined shot area SH of the plurality of the shot areas SH on the wafer 100.

As described above, in the high NA-EUV exposure, the mask magnification is, for example, 4×8 times, and the pair of photomasks 10 is combined to expose the entire area of the shot area SH corresponding to the 4×8 time mask magnification. Therefore, in the processing of Fig. 3B, the photoresist layer 120 is exposed in an area approximately half of the shot area SH. As described above, the area exposed by one of the photomasks 10 is referred to as the exposed area EX1.

In the exposed area EX1, a pattern having a similar shape to the light-shielding pattern P1 of the one of the photomasks 10 is transferred to the photoresist layer 120. However, in the exposed area EX1, the area (exposed area Dex) corresponding to the stitching area ST of the photomask 10 is irradiated with exposure light attenuated (light L2), and therefore the photoresist layer 120 may have a degree of photosensitivity that is lower than that of the other portion of the exposed area EX1.

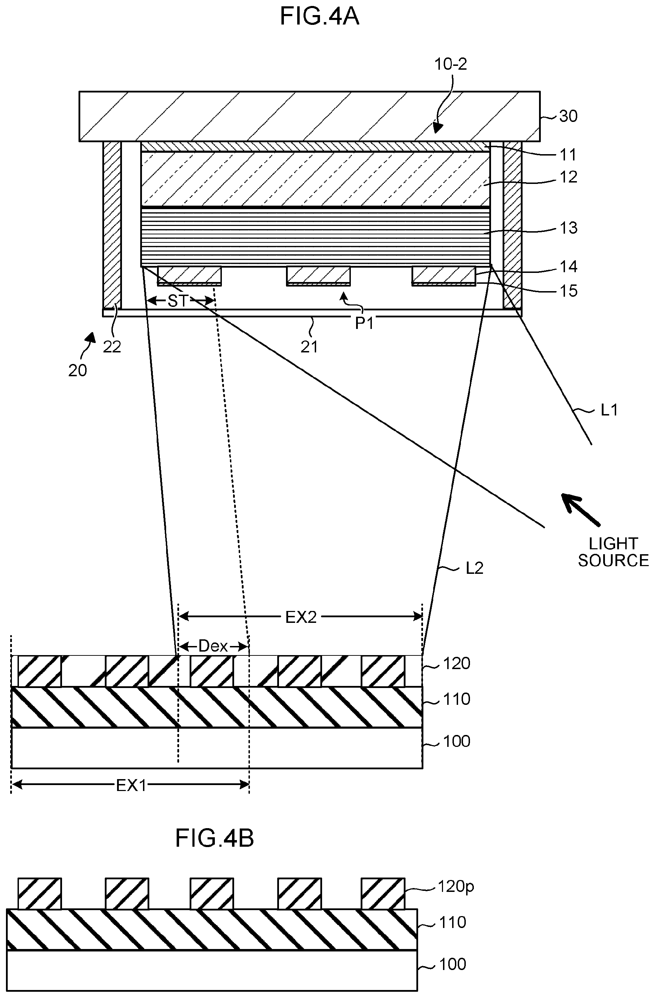

As illustrated in Fig. 4A, the other (e.g., photomask 10-2) of the pair of photomasks 10 is mounted on the electrostatic chuck 30 of the exposure apparatus, and arranged at a predetermined position where the photomask faces the wafer 100 in the exposure apparatus. The light L1 such as EUV emitted from the light source LS (see Figs. 1B and 1C) of the exposure apparatus is reflected by the photomask 10, and the reflected light L2 is applied to the photoresist layer 120 of the shot area SH described above.

Therefore, the photoresist layer 120 is exposed in a remaining area approximately half of the shot area SH. As described above, the area exposed by the other photomask 10 is referred to as the exposed area EX2.

In the exposed area EX2, a pattern having a similar shape to the light-shielding pattern P1 of other photomask 10 is transferred to the photoresist layer 120.

Furthermore, in the exposed area Dex in which the exposed areas EX1 and EX2 overlap each other and which is subjected to double exposure, the light intensity per one time is suppressed by the stitching area ST included in each of the pair of photomasks 10. Therefore, at the end of the second exposure, a total light intensity is substantially equal to those of the other portions of the exposed areas EX1 and EX2, and the degree of photosensitivity of the photoresist layer 120 is also substantially equal to those of the other portions.

As illustrated in Fig. 4B, when the exposed photoresist layer 120 by using the two photomasks 10 is developed, a resist pattern 120p to which the light-shielding patterns P1 of the photomasks 10 are transferred can be obtained. The function of the stitching areas ST included in the photomasks 10 reduces the critical dimension loss of the resist pattern 120p even in the exposed area Dex subjected to double exposure.

This is the end of exposure processing by using the photomasks 10 of the first embodiment.

Thereafter, the resist pattern 120p obtained by heating treatment and development after the exposure is used to process the processed layer 110 on the wafer 100.

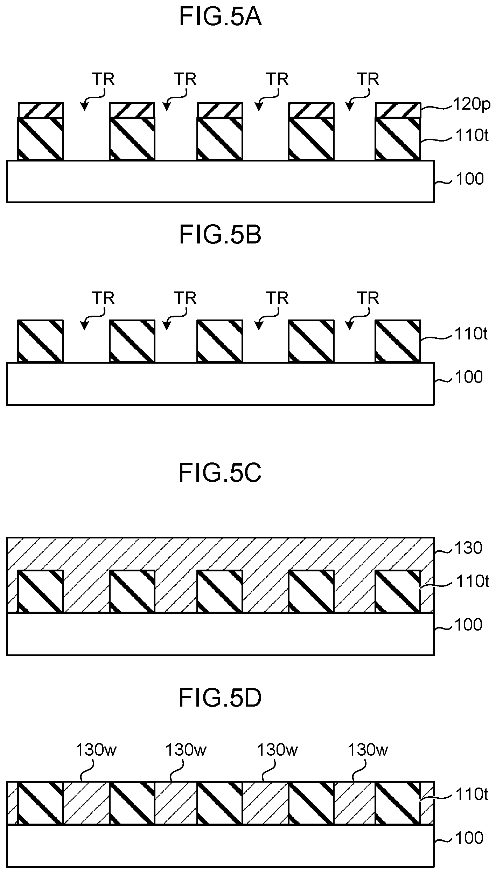

Figs. 5A to 5D are cross-sectional views each illustrating a part of a procedure of a processing method for the wafer 100 according to the first embodiment.

As illustrated in Fig. 5A, the resist pattern 120p is used as a mask, the processed layer 110 is processed, for example, by RIE or the like to form a processed layer 110t including, for example, a plurality of grooves TR.

As illustrated in Fig. 5B, the resist pattern 120p is removed by ashing using oxygen plasma or the like.

As illustrated in Fig. 5C, the grooves TR of the processed layer 110t are filled with a conductive layer 130 such as a Cu layer. The conductive layer 130 is formed to also cover an upper surface of the processed layer 110t.

As illustrated in Fig. 5D, the conductive layer 130 covering the upper surface of the processed layer 110t is removed by chemical mechanical polishing (CMP) or the like. Therefore, a plurality of wires 130w in which the grooves TR of the processed layer 110t are filled with the conductive layer 130 are formed.

Thus, pattern forming processing for the processed layer 110 and the processing of the wafer 100 of the first embodiment are finished.

The wires 130w formed as described above partially constitute, for example, a semiconductor device. In other words, the exposure method using the photomasks 10 and the pattern formation processing for the processed layer 110 of the first embodiment illustrated in Figs. 3A to 5D are included in a semiconductor device manufacturing method.

### (Conclusion)

In order to maintain the exposed area on the wafer that is enabled to be exposed using the photomask having a mask magnification of, for example, 4×4 times in low NA exposure, the mask magnification is, for example, 4×8 times in the high NA-EUV exposure. When the size of a conventional photomask is maintained, the exposure processing is performed in some cases in which two photomasks having substantially the same size as that of the conventional photomask are combined by a technique of stitching. In this case, in order to align the transferred patterns or the like over the two exposed areas, these exposed areas partially overlap each other in some cases. At this time, increase in the critical dimension loss of the transferred pattern becomes an issue in a double exposure portion generated at a joint between the two photomasks in the exposed area.

Therefore, for example, it has been proposed that a pattern requiring precise control of the critical dimension loss such as a fine pattern is not arranged in the stitching area (stitching band), the resolution of the stitching area is adjusted to obtain appropriate resolution by double exposure (at-resolution stitching), or on/off control of the light source during exposure controls the light intensity in the stitching area to have a gradient (dose-gradient stitching).

However, the first approach requires a large change in design, the second approach is likely to cause process fluctuation, and the third approach makes it difficult to obtain accuracy in positional of the light source to be turned on/off.

The photomasks 10 of the first embodiment are each configured so that the reflection intensity of the exposure light decreases from the end portion E31 of the stitching area ST located inside the photomask 10 toward the other end portion E32 of the stitching area ST located at the end portion E12 on the one side of the photomask 10. This configuration makes it possible to suppress the critical dimension loss caused by double exposure due to overlapping of the exposed areas EX1 and EX2.

According to the photomasks 10 of the first embodiment, the coverage of the light-shielding pattern P2 increases, from the end portion E31 of the stitching area ST located inside the photomask 10 toward the other end portion E32 of the stitching area ST located at the end portion E12 on the one side of the photomask 10. This configuration makes it possible to reduce the reflection intensity of the exposure light to suppress the critical dimension loss caused by double exposure due to overlapping of the exposed areas EX1 and EX2.

According to the photomasks 10 of the first embodiment, in the light-shielding pattern P22a, the number of dots per unit area increases from the end portion E31 of the stitching area ST located inside the photomask 10 toward the other end portion E32 of the stitching area ST located at the end portion E12 on the one side of the photomask 10. This configuration makes it possible to increase the coverage of the light-shielding pattern P22a toward the end portion E12 of the photomask 10 to reduce the reflection intensity of the exposure light.

According to the photomasks 10 of the first embodiment, in the light-shielding pattern P22b, the individual dots have areas increasing from the end portion E31 of the stitching area ST located inside the photomask 10 toward the other end portion E32 of the stitching area ST located at the end portion E12 on the one side of the photomask 10. This configuration makes it possible to increase the coverage of the light-shielding pattern P22b toward the end portion E12 of the photomask 10 to reduce the reflection intensity of the exposure light.

According to the photomasks 10 of the first embodiment, in the light-shielding pattern P22c, the number of dots per unit area increases and the individual dots have areas increasing from the end portion E31 of the stitching area ST located inside the photomask 10 toward the other end portion E32 of the stitching area ST located at the end portion E12 on the one side of the photomask 10. This configuration makes it possible to increase the coverage of the light-shielding pattern P22c toward the end portion E12 of the photomask 10 to reduce the reflection intensity of the exposure light.

According to the photomasks 10 of the first embodiment, in the light-shielding pattern P21a, the number of lines per unit area increases from the end portion E31 of the stitching area ST located inside the photomask 10 toward the other end portion E32 of the stitching area ST located at the end portion E12 on the one side of the photomask 10. This configuration makes it possible to increase the coverage of the light-shielding pattern P21a toward the end portion E12 of the photomask 10 to reduce the reflection intensity of the exposure light.

According to the photomasks 10 of the first embodiment, in the light-shielding pattern P21b, the individual lines have widths increasing from the end portion E31 of the stitching area ST located inside the photomask 10 toward the other end portion E32 of the stitching area ST located at the end portion E12 on the one side of the photomask 10. This configuration makes it possible to increase the coverage of the light-shielding pattern P21b toward the end portion E12 of the photomask 10 to reduce the reflection intensity of the exposure light.

According to the photomasks 10 of the first embodiment, in the light-shielding pattern P21c, the number of lines per unit area increases and the individual lines have widths increasing from the end portion E31 of the stitching area ST located inside the photomask 10 toward the other end portion E32 of the stitching area ST located at the end portion E12 on the one side of the photomask 10. This configuration makes it possible to increase the coverage of the light-shielding pattern P21c toward the end portion E12 of the photomask 10 to reduce the reflection intensity of the exposure light.

### (First modification)

In the first embodiment described above, the coverage of the light-shielding pattern P2 is changed to change the reflection intensity in the stitching area ST of each photomask 10. However, the approach to change the reflection intensity of the photomask is not limited to this.

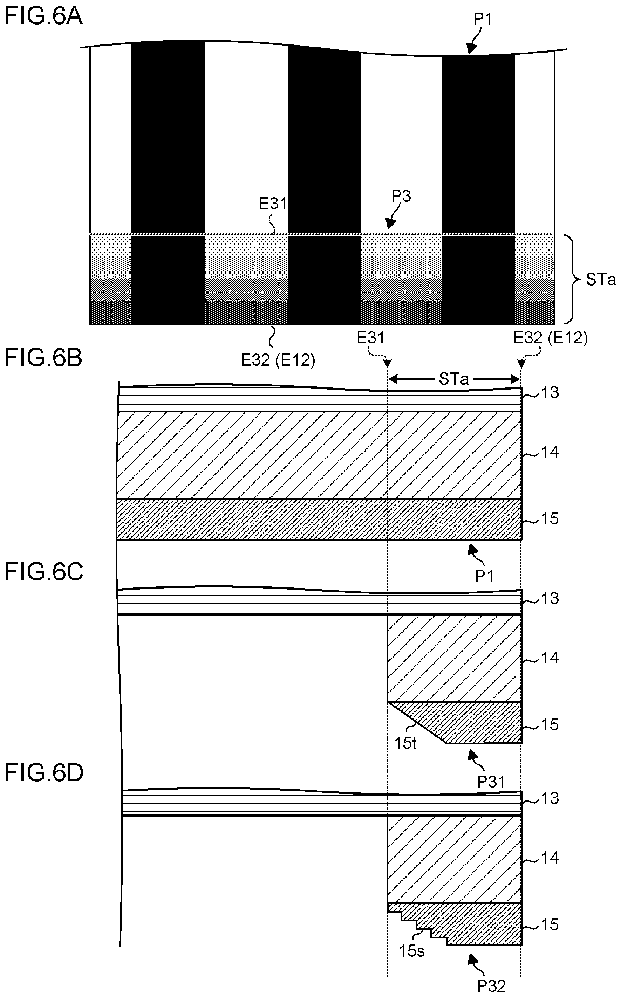

An example of changing the reflection intensity of the photomask by changing the thickness of the light-absorbing layer 15 of a light-shielding pattern P3 will be described below with reference to Figs. 6A to 6D.

Figs. 6A to 6D are schematic diagrams illustrating exemplary configurations of the light-shielding patterns P1 and P3 provided on a surface of a photomask according to a first modification of the first embodiment facing the wafer. More specifically, Fig. 6A is a plan view illustrating an exemplary configuration of the light-shielding patterns P1 and P3, and Figs. 6B to 6D are cross-sectional views illustrating exemplary configurations of the light-shielding patterns P1 and P3.

Note that in Figs. 6A to 6D, configurations similar to those of the above first embodiment are denoted by the same reference numerals, and the description thereof is not repeated in some cases.

As illustrated in Figs. 6A to 6D, similarly to the light-shielding pattern P1, the light-shielding pattern P3 is a pattern including the light-absorbing layer 15 and the buffer layer 14 provided on the reflective layer 13, and is arranged between the light-shielding patterns P1 in a stitching area STa included in the photomask of the first modification.

In addition, while the light-absorbing layer 15 of the light-shielding pattern P1 has a constant thickness, the light-absorbing layer 15 is configured to gradually increase in thickness, in the light-shielding pattern P3, from the end portion E31 of the stitching area STa closer to the center of the photomask toward the other end portion E32 of the stitching area ST located at the end portion E12 on one side of the photomask.

The light-absorbing layer 15 has a predetermined absorptivity with respect to the exposure light, and the light intensity of the exposure light reaching the reflective layer 13 without being absorbed by the light-absorbing layer 15 varies depending on the thickness of the light-absorbing layer 15. More specifically, as the light-absorbing layer 15 is reduced in thickness, the exposure light is not absorbed and it is facilitated to reach the reflective layer 13, and as the light-absorbing layer 15 has a larger thickness, the exposure light is absorbed and it is difficult to reach the reflective layer 13. Therefore, increasing the thickness of the light-absorbing layer 15 toward the end portion E12 of the photomask reduces the light intensity of the exposure light reaching the reflective layer 13, enabling reduction of the reflection intensity per unit area of the photomask 10.

In the example illustrated in Fig. 6C, the light-shielding pattern P31 as the light-shielding pattern P3 has an inclined surface 15t that is gradually inclined, and thus, the light-shielding pattern P31 has a thickness increasing from one end portion E31 to the other end portion E32 of the stitching area STa. At this time, the light-shielding pattern P31 is allowed to be configured so that the light-absorbing layer 15 has a layer thickness that is minimized or substantially zero at the end portion E31 of the stitching area STa closer to the center of the photomask and the light-absorbing layer 15 has a thickness that is equal to or larger than that of the light-absorbing layer 15 of the light-shielding pattern P1 at a position reaching a predetermined distance from a position closer to the center of the photomask.

For example, the light-shielding patterns P1 and P31 configured as described above can be formed as follows.

The buffer layer 14 and the light-absorbing layer 15 are formed in this order, over the entire surface of the reflective layer 13. Furthermore, portions of the light-absorbing layer 15 serving as the light-shielding patterns P1 and P31 are covered with a resist pattern or the like, and etching is performed sequentially under the condition that the light-absorbing layer 15 and the buffer layer 14 have an anisotropic shape by RIE or the like. In addition, after the resist pattern is once peeled off, a resist pattern or the like exposing a portion serving as the inclined surface 15t of the light-absorbing layer 15 is further formed, and etching is additionally performed on condition that the light-absorbing layer 15 has a footing shape. In order to form the light-absorbing layer 15 into the footing shape, for example, an approach to, for example, retract the resist pattern during etching under the condition that a by-product of the etching is readily deposited or under the condition of selectivity to the resist pattern is low can be taken.

Therefore, the light-shielding pattern P1 including the light-absorbing layer 15 and the buffer layer 14 that have a substantially vertical shape and a light-shielding pattern P31 including the light-absorbing layer 15 of footing shape including the inclined surface 15t are formed.

In the example illustrated in Fig. 6D, a light-shielding pattern P32 as the light-shielding pattern P3 includes a stepped portion 15s that has a stair profile instead of the inclined surface 15t gradually inclined, and thus, the light-shielding pattern P32 has a thickness increasing stepwise from one end portion E31 to the other end portion E32 of the stitching area STa. At this time as well, the light-shielding pattern P32 is allowed to be configured so that the light-absorbing layer 15 has a layer thickness that is minimized or substantially zero at the end portion E31 of the stitching area STa closer to the center of the photomask and the light-absorbing layer 15 has a thickness that is equal to or larger than that of the light-absorbing layer 15 of the light-shielding pattern P1 at a position reaching a predetermined distance from a position closer to the center of the photomask.

For example, the light-shielding patterns P1 and P32 configured as described above can be formed as follows.

Processing can be performed as in the light-shielding pattern P31 described above, until the light-shielding pattern P1 is formed and the first resist pattern is once formed. After the resist pattern is once peeled off, a resist pattern or the like partially exposing a portion serving as the stepped portion 15s of the light-absorbing layer 15 is further formed, and slimming of the resist pattern and etching of the light-absorbing layer 15 are repeated a plurality of times.

Therefore, the light-shielding pattern P1 including the light-absorbing layer 15 and the buffer layer 14 that have a substantially vertical shape and a light-shielding pattern P31 including the light-absorbing layer 15 including the stepped portion 15s.

According to the photomask of the first modification, in the light-shielding pattern P3, the light-absorbing layer 15 has a thickness increasing from the end portion E31 of the stitching area STa located inside the photomask of the first modification toward the other end portion E32 of the stitching area STa located at the one end portion E12 on one side of the photomask.

This configuration makes it possible to increase an amount of exposure light absorbed by the light-shielding pattern P3 toward the end portion E12 of the photomask of the first modification to reduce the reflection intensity of the exposure light in the photomask of the first modification. Therefore, it is possible to suppress the critical dimension loss caused by double exposure due to overlapping of the exposed areas EX1 and EX2.

According to the photomask of the first modification, in the light-shielding pattern P31, the light-absorbing layer 15 has the inclined surface 15t gradually inclined from the end portion E31 of the stitching area STa located inside the photomask of the first modification toward the other end portion E32 of the stitching area STa located at the one end portion E12 on the one side of the photomask. This configuration makes it possible to increase an amount of exposure light absorbed by the light-shielding pattern P31 toward the end portion E12 of the photomask of the first modification to reduce the reflection intensity of the exposure light in the photomask of the first modification.

According to the photomask of the first modification, in the light-shielding pattern P32, the light-absorbing layer 15 has a thickness increasing from the end portion E31 of the stitching area STa located inside the photomask of the first modification toward the other end portion E32 of the stitching area STa located at the one end portion E12 on the one side of the photomask. This configuration makes it possible to increase an amount of exposure light absorbed by the light-shielding pattern P32 toward the end portion E12 of the photomask of the first modification to reduce the reflection intensity of the exposure light in the photomask of the first modification.

In addition, the photomask of the first modification has the effect similar to those of the first embodiment described above.

### (Second modification)

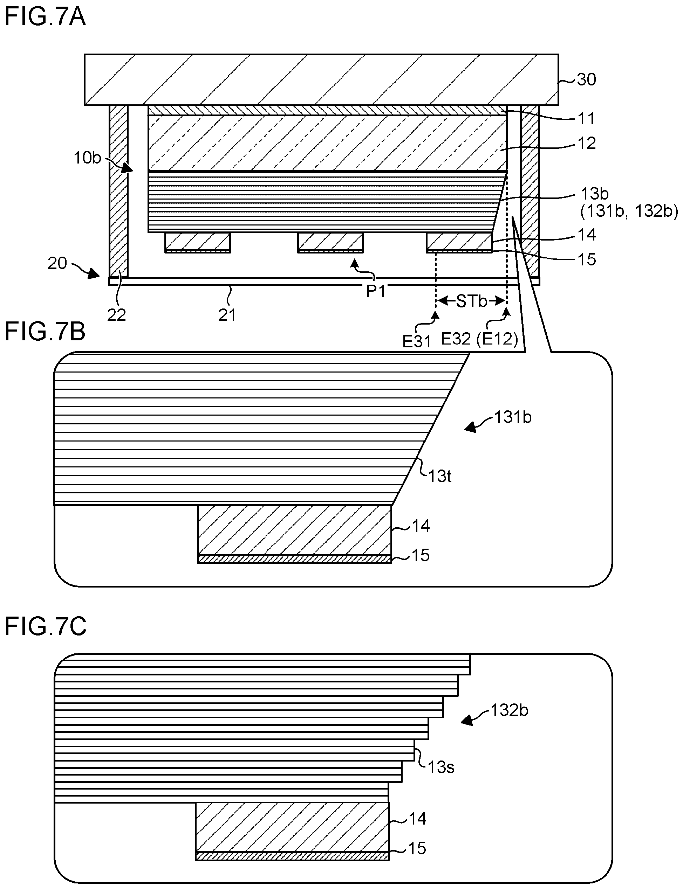

Next, a photomask 10b of a second modification will be described with reference to Figs. 7A to 7C, as still another approach to change the reflection intensity of the photomask.

Figs. 7A to 7C are schematic diagrams each illustrating an exemplary configuration of the photomask 10b according to the second modification of the first embodiment. More specifically, Fig. 7A is a cross-sectional view of the photomask 10b with the pellicle 20 mounted thereon, and Figs. 7B and 7C are enlarged cross-sectional views illustrating some examples of a reflective layer 13b included in the photomask 10b.

Note that in Figs. 7A to 7C, configurations similar to those of the above first embodiment are denoted by the same reference numerals, and the description thereof is not repeated in some cases.

As illustrated in Fig. 7A, the photomask 10b includes the reflective layer 13b (131b and 132b) that has a thickness reduced toward the end portion E12 of the photomask 10b, instead of the reflective layer 13 of the first embodiment described above. For example, the photomask 10b has the light-shielding pattern P1 as in the first embodiment, and the reflective layer 13b exposed from the light-shielding pattern P1 has a thickness reduced toward the end portion E12 of the photomask 10b.

In the reflective layer 13b, a reflectance of the exposure light such as EUV varies depending on the thickness thereof. More specifically, the reflective layer 13b has, for example, a multilayer structure in which a plurality of Mo layers and a plurality of Si layers are alternately stacked one by one, similarly to the reflective layer 13 of the first embodiment described above, and exposure light is diffracted by each of these layers and reflected to the outside of the reflective layer 13b. Therefore, as the reflective layer 13b is reduced in thickness and the number of stacked layers is reduced, the reflectance of the exposure light decreases, and as the reflective layer 13b is increased in thickness and the number of stacked layers is increased, the reflectance of the exposure light is increased.

Therefore, reducing the thickness of the reflective layer 13b toward the end portion E12 of the photomask 10b reduces the reflectance of the exposure light, enabling reduction of the reflection intensity per unit area of the photomask 10b.

In the example illustrated in Fig. 7B, the reflective layer 131b as the reflective layer 13b has an inclined surface 13t that is gradually inclined, and thus, the reflective layer 131b has a thickness gradually reducing from the one end portion E31 to the other end portion E32 of a stitching area STb. At this time, the reflective layer 131b is allowed to be configured so that the reflective layer 131b has a layer thickness that is maximum at the end portion E31 of the stitching area STb closer to the center of the photomask 10b, that is, a thickness that is sufficient to obtain the reflectance for exposure of the photoresist layer or the like and the reflective layer 131b has a thickness that is minimized or substantially zero at the position of the end portion E12 of the photomask 10b.

For example, the reflective layer 131b configured as described above can be formed as follows.

The reflective layer 13 configured similarly to the first embodiment is formed over the entire surface of the glass substrate 12, a resist pattern or the like exposing a portion serving as the inclined surface 13t of the reflective layer 131b is formed, and etching is performed on condition that the reflective layer 13 has a footing shape. In order to form the reflective layer 13b into the footing shape, for example, an approach of, for example, retraction of the resist pattern during etching under the condition that a by-product of the etching is readily deposited or under the condition of selectivity to the resist pattern is low can be taken.

As described above, the reflective layer 131b of footing shape including the inclined surface 13t is formed.

In the example illustrated in Fig. 7C, the reflective layer 132b as the reflective layer 13b includes a stepped portion 13s that has a stair profile instead of the inclined surface 13t gradually inclined, and thus, the reflective layer 132b has a thickness reducing stepwise from one end portion E31 to the other end portion E32 of the stitching area STb. The shape of the reflective layer 132b configured in this way is obtained, for example, by processing a plurality of Mo layers and Si layers included in the reflective layer 132b into a stair profile.

At this time, the reflective layer 132b is allowed to be configured so that the number of stacked layers of the reflective layer 132b is maximum at the end portion E31 of the stitching area STb closer to the center of the photomask 10b, that is, the number of stacked layers is sufficient to obtain the reflectance for exposure of the photoresist layer or the like and the number of stacked layers of the reflective layer 132b is minimized or substantially zero at the position of the end portion E12 of the photomask 10b.

For example, the reflective layer 132b configured as described above can be formed as follows.

The reflective layer 13 of the first embodiment is formed over the entire surface of the glass substrate 12, a resist pattern or the like partially exposing a portion serving as the stepped portion 13s of the reflective layer 132b is formed, and slimming of the resist pattern and etching of a plurality of the Mo layers and Si layers of the reflective layer 13 are repeated a plurality of times.

As described above, the reflective layer 132b including the stepped portion 13s is formed.

Note that when the Mo layers and the Si layers of the reflective layer 132 are formed by sputtering or the like, it is also possible to form the stepped portion 13s in a step of forming the reflective layer 132.

In this case, a shielding plate or the like is arranged between the glass substrate 12 on which the reflective layer 132 is formed and a sputtering target, and the position of the shielding plate is gradually shifted so that sputtered particles adhere and reduce a range in which the Mo layers and the Si layers are formed. This approach as described above also enables formation of the reflective layer 132b having the stepped portion 13s.

According to the photomask 10b of the second modification, the reflective layer 13b is reduced in thickness, from the end portion E31 of the stitching area STb located inside the photomask 10b toward the other end portion E32 of the stitching area STb located at the end portion E12 on one side of the photomask 10b.

This configuration makes it possible to reduce the reflectance of the exposure light by the reflective layer 13b toward the end portion E12 of the photomask 10b to reduce the reflection intensity of the exposure light. Therefore, it is possible to suppress the critical dimension loss caused by double exposure due to overlapping of the exposed areas EX1 and EX2.

According to the photomask 10b of the second modification, the reflective layer 131b has the inclined surface 13t that is gradually inclined from the end portion E31 of the stitching area STb located inside the photomask 10b toward the other end portion E32 of the stitching area STb located at the end portion E12 on one side of the photomask 10b. This configuration makes it possible to reduce the reflectance of the exposure light by the reflective layer 131b toward the end portion E12 of the photomask 10b to reduce the reflection intensity of the exposure light.

According to the photomask 10b of the second modification, the reflective layer 132b is reduced stepwise in thickness as extension distances of a plurality of Mo layers and Si layers decrease, from the end portion E31 of the stitching area STb located inside the photomask 10b toward the other end portion E32 of the stitching area STb located at the end portion E12 on one side of the photomask 10b. This configuration makes it possible to reduce the reflectance of the exposure light by the reflective layer 132b toward the end portion E12 of the photomask 10b to reduce the reflection intensity of the exposure light.

In addition, the photomask 10b of the second modification has the effect similar to those of the first embodiment described above.

### [Second Embodiment]

In the first embodiment described above, on the basis of the configurations of the units included in the photomasks 10 and 10b and the like, the reflection intensity of the photomasks 10 and 10b themselves has been changed to adjust the light intensity in the exposed area Dex subjected to double exposure. However, the approach to adjust the light intensity of a double exposure area is not limited thereto.

Hereinafter, a configuration of a second embodiment to adjust the light intensity of the double exposure area by using an approach different from that of the first embodiment will be described in detail with reference to the drawings. Note that in the following drawings, configurations similar to those of the above first embodiment are denoted by the same reference numerals, and the description thereof is not repeated in some cases.

### (Exemplary configuration of pellicle)

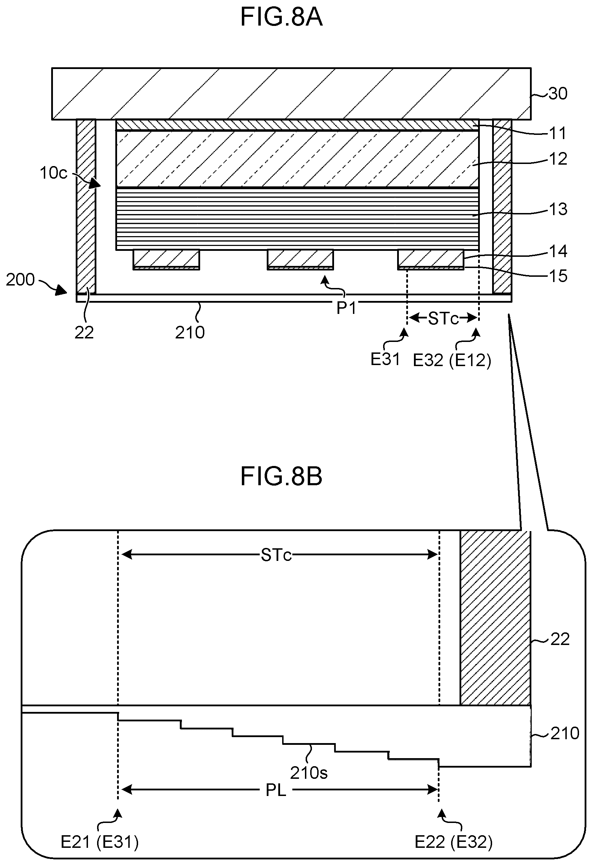

Figs. 8A and 8B are schematic diagrams each illustrating an exemplary configuration of a photomask 10c according to the second embodiment. More specifically, Fig. 8A is a cross-sectional view of the photomask 10c with the pellicle 200 mounted thereon, and Fig. 8B is an enlarged cross-sectional view of the pellicle 200.

As illustrated in Fig. 8A, he photomask 10c includes the conductive layer 11, the glass substrate 12, the reflective layer 13, and the light-shielding pattern P1 including the buffer layer 14 and the light-absorbing layer 15. Furthermore, a stitching area STc is provided near the end portion E12 on one side of the photomask 10c.

The pellicle 200 includes a protective layer 210 and the frame 22.

The protective layer 210 is, for example, a carbon nanotube layer or the like, and has a thickness changing in an area PL that corresponds to the stitching area STc and through which exposure light reflected from the stitching area STc passes. More specifically, the protective layer 210 has a thickness increasing from one end portion E21 to the other end portion E22 of the area PL corresponding to the stitching area STc.

Here, the end portion E21 of the area PL is at a position corresponding to the end portion E31 of the stitching area STc closer to the center of the photomask 10c, and the end portion E22 of the area PL is at a position corresponding to the other end portion E32 of the stitching area ST located at the end portion E12 of the photomask 10c.

As illustrated in Fig. 8B, the protective layer 210 whose thickness changes as described above includes a stepped portion 210s having a stair profile.

The protective layer 210 has high transmittance to exposure light such as EUV, as described above, but increasing the thickness of the protective layer 210 enables to reduce the transmittance of the exposure light. Therefore, increasing the thickness of the protective layer 210 toward a position corresponding to the end portion E12 of the photomask 10c reduces the light intensity of the exposure light passing through the protective layer 210 and reaching the reflective layer 13, enabling reduction of the reflection intensity per unit area of the photomask 10c.

The pellicle 200 of the second embodiment may also further include an oxidation-inhibiting layer that covers the protective layer 210 to inhibit oxidation of the protective layer 210.

### (Method of manufacturing pellicle)

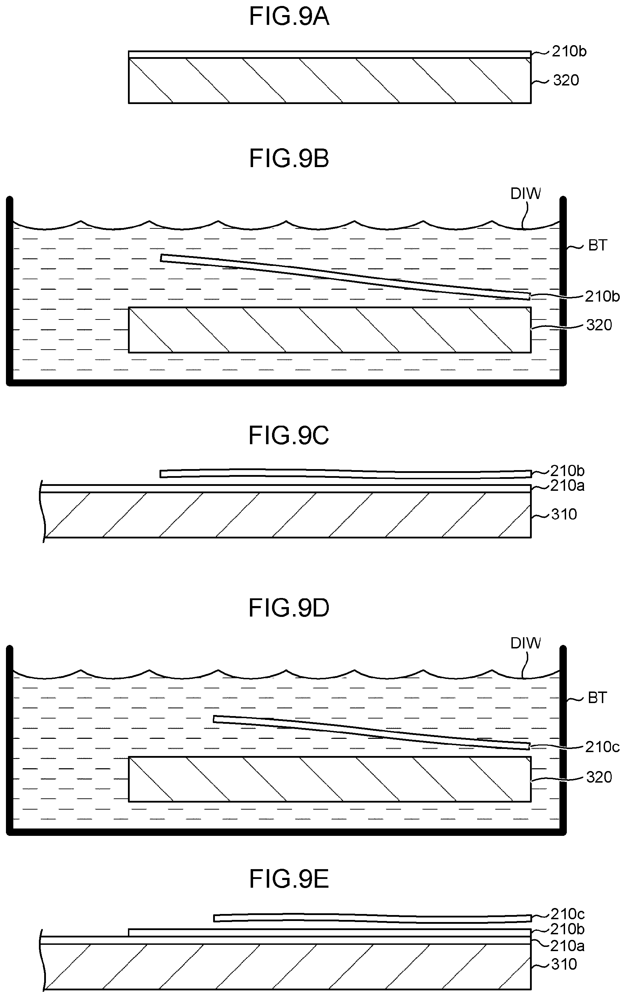

Next, a method of manufacturing the pellicle 200 according to the second embodiment will be described with reference to Figs. 9A to 10F. Figs. 9A to 10F are cross-sectional views sequentially illustrating a part of the method of manufacturing the pellicle 200 according to the second embodiment.

As illustrated in Fig. 9A, a thin layer 210b such as a carbon nanotube layer is formed on a support substrate 320 by CVD or the like.

As illustrated in Fig. 9B, the support substrate 320 on which the thin layer 210b is formed is immersed in deionized water or the like in an immersion tank BT, and the thin layer 210b is peeled off from the support substrate 320.

As illustrated in Fig. 9C, a thin layer 210a such as a carbon nanotube layer is formed on a support substrate 310 different from the support substrate 320 by CVD or the like so that the thin layer 210a has an extension distance longer than that of the thin layer 210b, and then the thin layer 210b peeled off as described above is overlaid on the thin layer 210a.

As illustrated in Fig. 9D, a thin layer 210c having an extension distance shorter than that of the thin layer 210b is formed on the support substrate 320 by CVD or the like, immersed in the immersion tank BT, and peeled off.

As illustrated in Fig. 9E, the thin layer 210c is overlaid and applied to the thin layer 210b of the support substrate 310.

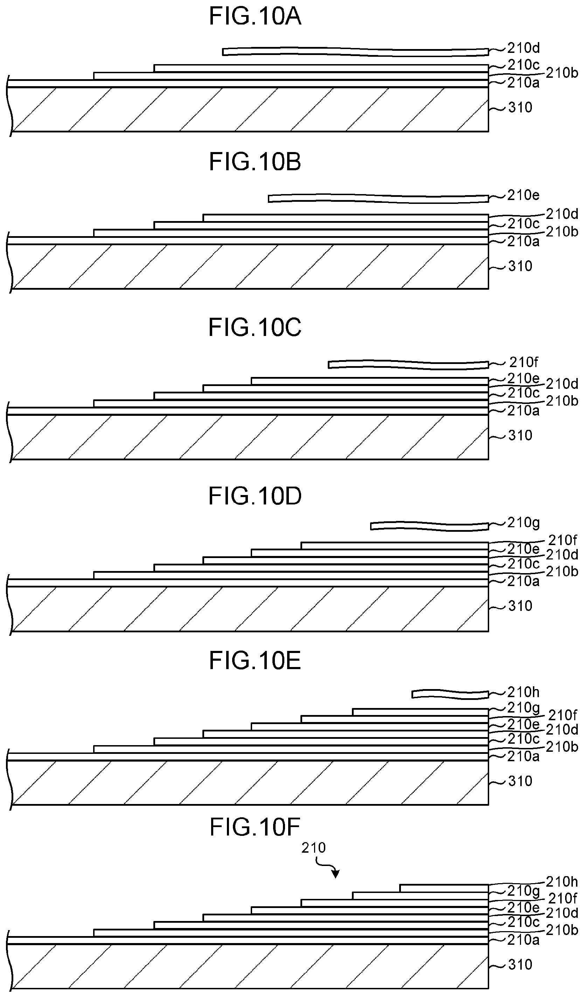

As illustrated in Figs. 10A to 10F, the above processing is repeated, and thin layers 210d to 210h such as carbon nanotube layers are sequentially overlaid and applied on the thin layer 210c of the support substrate 310. As a result, the protective layer 210 in which a plurality of the thin layers 210a to 210h is stacked is formed.

Thereafter, the protective layer 210 is applied to the frame 22.

As described above, the pellicle 200 of the second embodiment is manufactured.

### (Conclusion)

According to the photomask 10c of the second embodiment, in the area PL of the pellicle 200, the protective layer 210 included in the pellicle 200 has a thickness increasing from the end portion E21 corresponding to an inner position of the photomask 10c toward the other end portion E22 corresponding to the end portion E12 on the one side of the photomask 10c.

This configuration makes it possible to reduce the light intensity of the exposure light reaching the reflective layer 13 toward the end portion E12 of the photomask 10c to reduce the reflection intensity of the exposure light. Therefore, it is possible to suppress the critical dimension loss caused by double exposure due to overlapping of the exposed areas EX1 and EX2.

In addition, the photomask 10c of the second embodiment has the effect similar to those of the first embodiment described above.

Note that in the second embodiment described above, the protective layer 210 is, for example, a carbon nanotube layer. However, the protective layer 210 of the second embodiment may be, for example, a graphene layer, a polyimide layer, a polysilicon layer, a silicon carbide layer, or the like, as described in the first embodiment described above. Even when the protective layer 210 uses these materials, changing the thickness thereof changes the transmittance of the exposure light or the like, and the above effect can be obtained.

### (First modification)

In the second embodiment described above, the protective layer 210 has been formed by overlaying the thin layers 210a to 201h such as carbon nanotube layers one by one. However, the method of forming the protective layer 210 whose thickness changes is not limited to the above description.

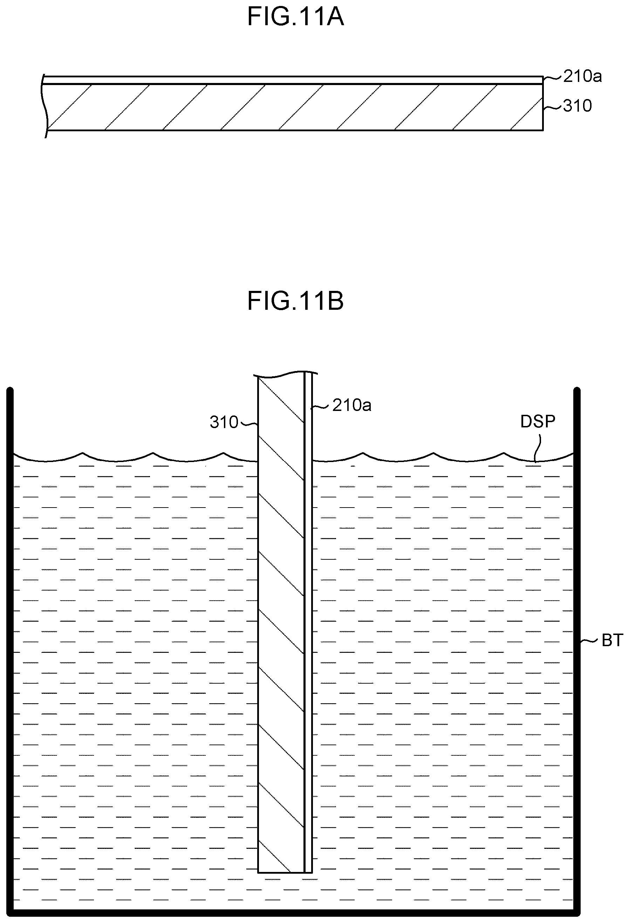

In the following first modification, an example of the method of forming the protective layer 210 by using an approach different from that of the second embodiment will be described with reference to Figs. 11A to 15. The first modification is different from the second embodiment described above in that the protective layer 210 is formed by immersion.

Figs. 11A to 15 are cross-sectional views sequentially illustrating a part of a method of manufacturing the pellicle 200 according to the first modification of the second embodiment. Note that in Figs. 11A to 15, configurations similar to those of the above second embodiment are denoted by the same reference numerals, and the description thereof may not be repeated.

As illustrated in Fig. 11A, the thin layer 210a such as a carbon nanotube layer is formed on the support substrate 310 by CVD or the like. However, the thin layer 210a may be formed by immersion or the like which is described in detail below.

As illustrated in Fig. 11B, the support substrate 310 on which the thin layer 210a is formed is partially immersed in a carbon nanotube dispersion liquid DSP in the immersion tank BT. The carbon nanotube dispersion liquid DSP is a liquid obtained by dispersing carbon nanotube molecules in deionized water, an organic solvent, or the like, and commercially available one can be used.

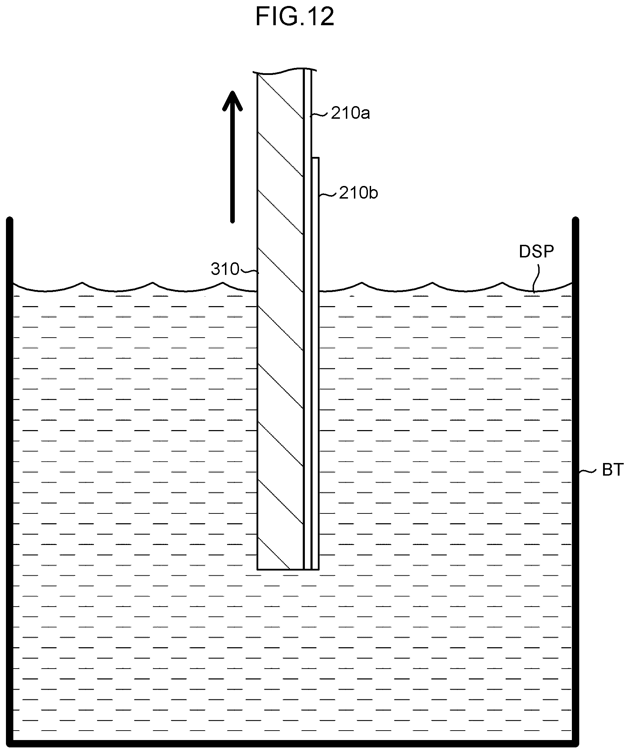

As illustrated in Fig. 12, when the support substrate 310 immersed in the carbon nanotube dispersion liquid DSP is pulled up from the dispersion liquid DSP, the new thin layer 210b such as a carbon nanotube layer is formed that partially covers the thin layer 210a on the support substrate 310.

At this time, the thin layer 210b may also be formed on a back surface side of the support substrate 310. Thereafter, illustration and description of thin layers formed on the back surface side of the support substrate 310 by repeating similar processing will not be repeated.

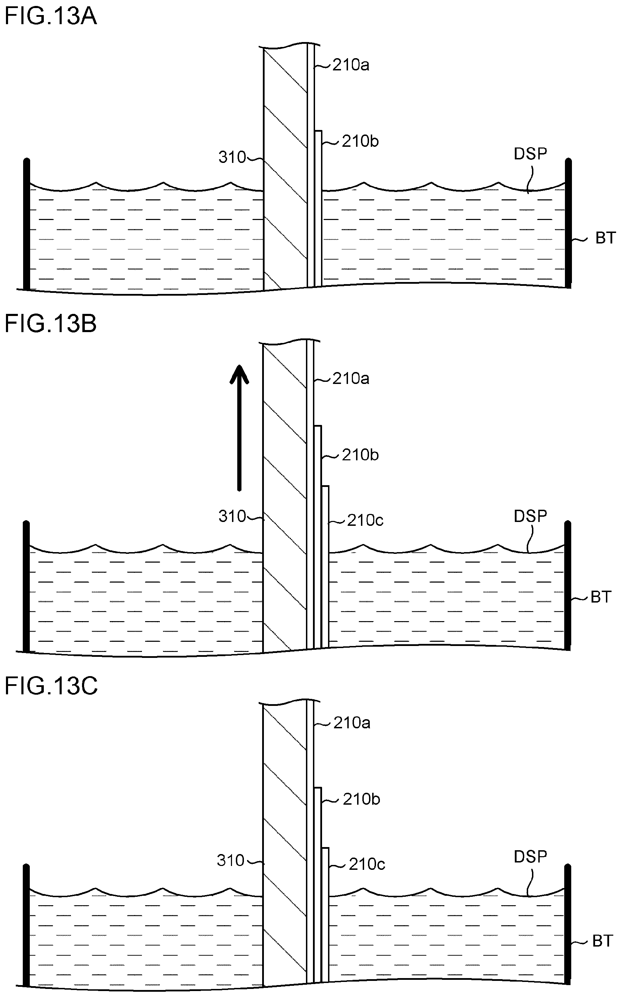

As illustrated in Fig. 13A, the support substrate 310 on which the thin layers 210a and 210b are formed is partially immersed in the dispersion liquid DSP. At this time, the support substrate 310 is immersed to a shallower depth than that in the processing illustrated in Fig. 11B.

As illustrated in Fig. 13B, when the support substrate 310 is pulled up from the dispersion liquid DSP, the thin layer 210c partially covering the thin layer 210b is newly formed.

As illustrated in Fig. 13C, the support substrate 310 on which the thin layers 210a to 210c are formed is partially immersed in the dispersion liquid DSP. At this time, the support substrate 310 is immersed to a further shallower depth than that in the processing illustrated in Fig. 12.

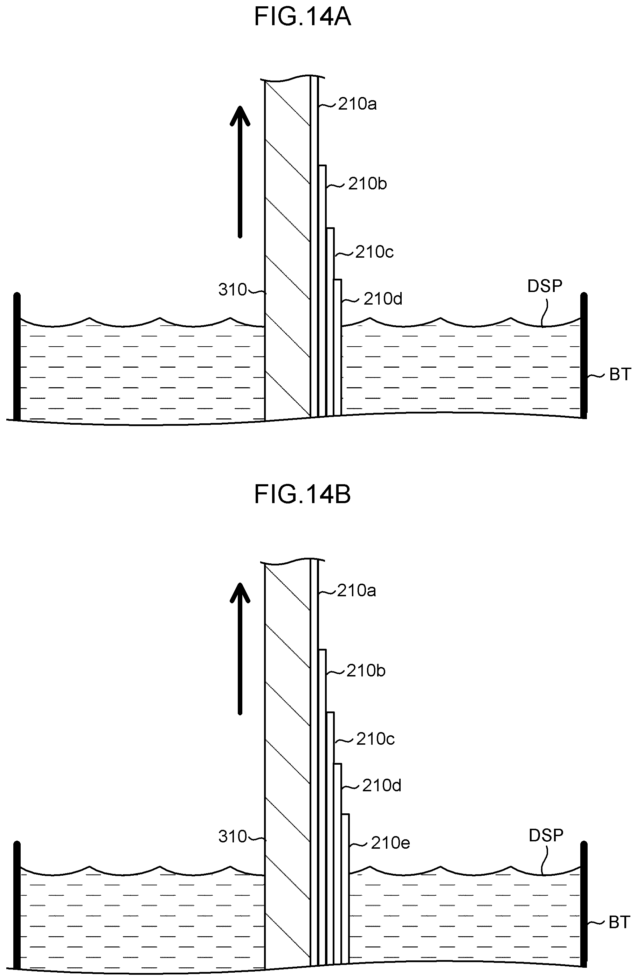

As illustrated in Fig. 14A, when the support substrate 310 is pulled up from the dispersion liquid DSP, the thin layer 210d partially covering the thin layer 210c is newly formed.

As illustrated in Fig. 14B, the support substrate 310 on which the thin layers 210a to 210d are formed is partially immersed in the dispersion liquid DSP. As a result, a new thin layer 210e partially covering the thin layer 210d is formed.

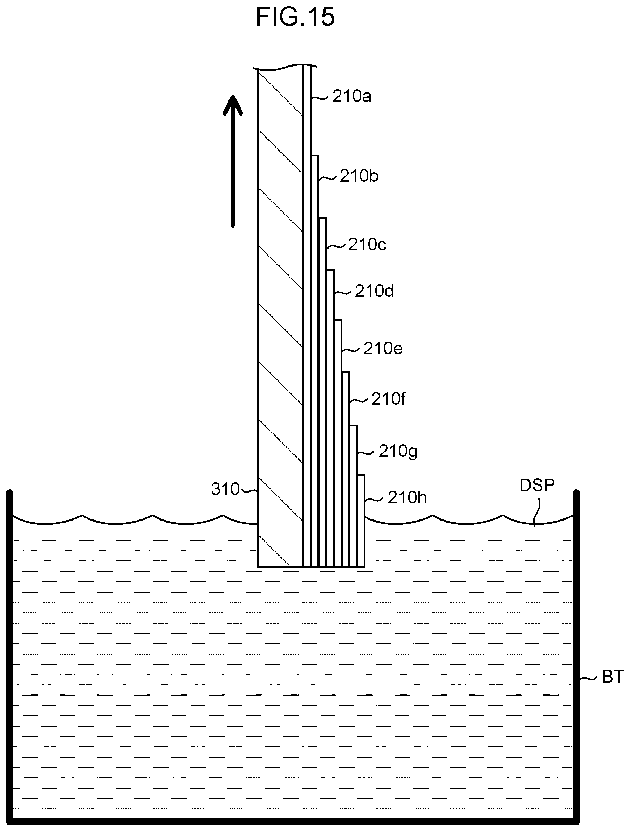

As illustrated in Fig. 15, when the above immersion treatment is repeated, the protective layer 210 can be obtained in which the thin layers 210a to 210h having extension distances gradually reduced are stacked.

Thereafter, the protective layer 210 is applied to the frame 22.

As described above, the pellicle 200 of the second embodiment is manufactured.

According to the method of manufacturing the pellicle 200 of the first modification, the pellicle 200 can be obtained that has the effect similar to that of the above second embodiment.

### (Second modification)

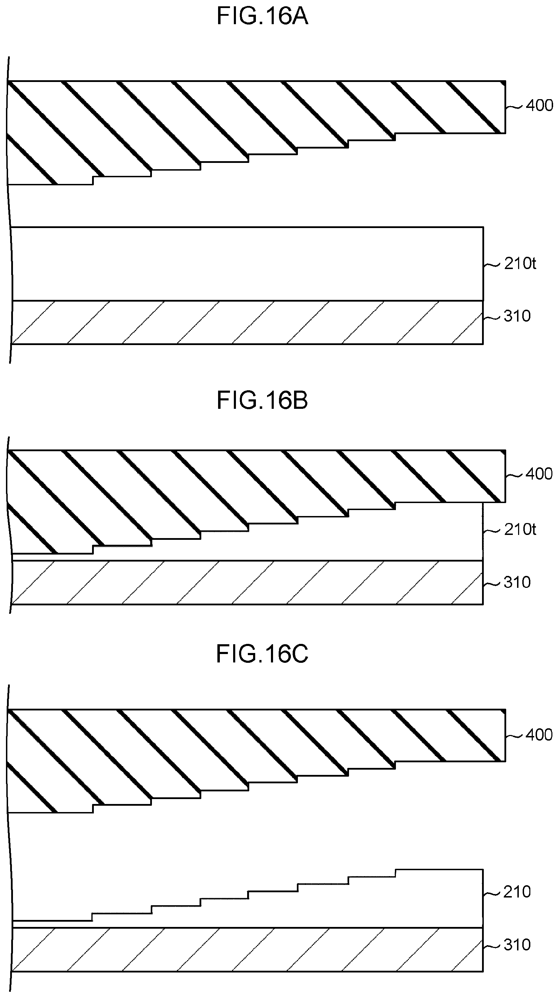

In the following second modification, an example of the method of forming the protective layer 210 by using an approach different from those of the second embodiment and the first modification will be described with reference to Figs. 16A to 16C. The second modification is different from the above second embodiment and the like in that the protective layer 210 is formed by compression.

Figs. 16A to 16C are cross-sectional views illustrating part of a method of manufacturing a pellicle 200 according to a second modification of the second embodiment. Note that in Figs. 16A to 16C, configurations similar to those of the above second embodiment are denoted by the same reference numerals, and the description thereof may not be repeated.

As illustrated in Fig. 16A, a thick layer 210t such as a carbon nanotube layer is formed on the support substrate 310. Such a layer 210t preferably has a low layer density, and can be formed by, for example, spraying the carbon nanotube dispersion liquid DSP described above onto the support substrate 310 by using, for example, a spray or the like which is not illustrated. The layer 210t may be formed by the above immersion treatment or the like.

In addition, a mold 400 having a stair profile is arranged to face the layer 210t on the support substrate 310. The mold 400 is allowed to be made of a material appropriately selected from various materials such as a metal, a ceramic, and a resin.

As illustrated in Fig. 16B, the mold 400 is pressed against the layer 210t on the support substrate 310, for compression molding of the layer 210t. As described above, the layer 210t is formed to have a low density, therefore, enabling compression by the mold 400 and molding into a desired shape. Note that It is preferable to adjust the layer density in forming the layer 210t so that a desired layer density is obtained after compression.

As illustrated in Fig. 16C, when the mold 400 is removed, the protective layer 210 can be obtained.

Thereafter, the protective layer 210 is applied to the frame 22.

As described above, the pellicle 200 of the second embodiment is manufactured.

According to the method of manufacturing the pellicle 200 of the second modification, the pellicle 200 can be obtained that has the effect similar to that of the above second embodiment.

### (Third modification)

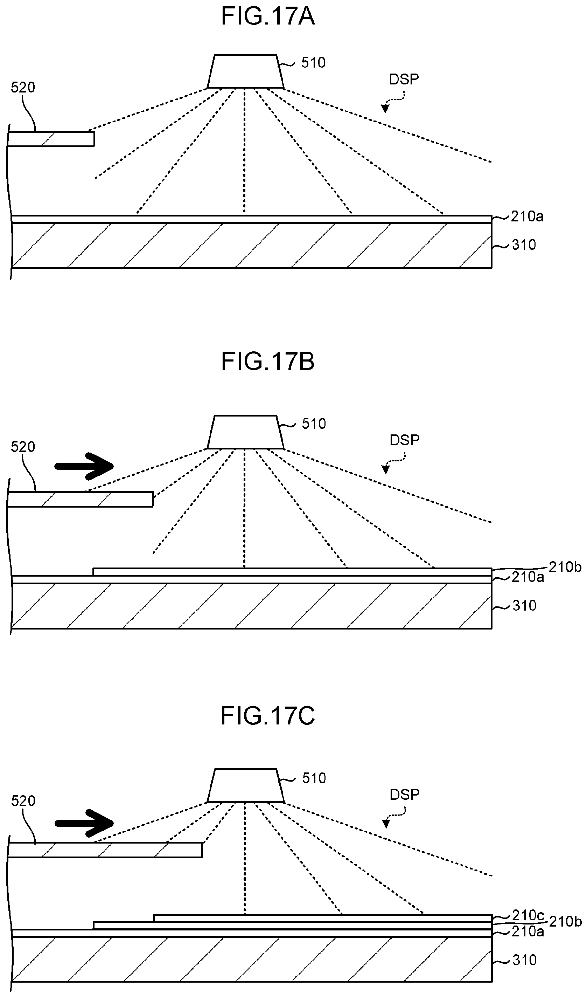

In the following third modification, an example of a method of forming the protective layer 210 by an approach further different from those of the second embodiment and the first and second modifications will be described with reference to Figs. 17A to 19B. The third modification is different from the above second embodiment and the like in that the protective layer 210 is formed by spraying.

Figs. 17A to 19B are cross-sectional views sequentially illustrating a part of a method of manufacturing a pellicle 200 according to the third modification of the second embodiment. Note that in Figs. 17A to 19B, configurations similar to those of the above second embodiment are denoted by the same reference numerals, and the description thereof may not be repeated.

As illustrated in Fig. 17A, the dispersion liquid DSP of carbon nanotubes or the like is sprayed by a spray 510 to form the thin layer 210a such as a carbon nanotube layer on the support substrate 310. In addition, a shielding plate 520 is arranged above the support substrate 310 on which the thin layer 210a is formed to partially shield the support substrate 310 from the dispersion liquid DSP sprayed by the spray 510.

The shielding plate 520 is allowed to be made of a material appropriately selected from various materials such as a metal, a ceramic, and a resin, as long as the material does not dissolved or degraded by the dispersion liquid DSP.

As illustrated in Fig. 17B, after the thin layer 210b that partially covers the thin layer 210a is formed by partially shielding the support substrate 310, the dispersion liquid DSP is sprayed in a state where the shielding plate 520 is slid to expand a shielded area.

As illustrated in Fig. 17C, after the thin layer 210c that partially covers the thin layer 210b is formed by expanding the shielded area of the support substrate 310, the dispersion liquid DSP is sprayed in a state where the shielding plate 520 is further slid to further expand the shielded area.

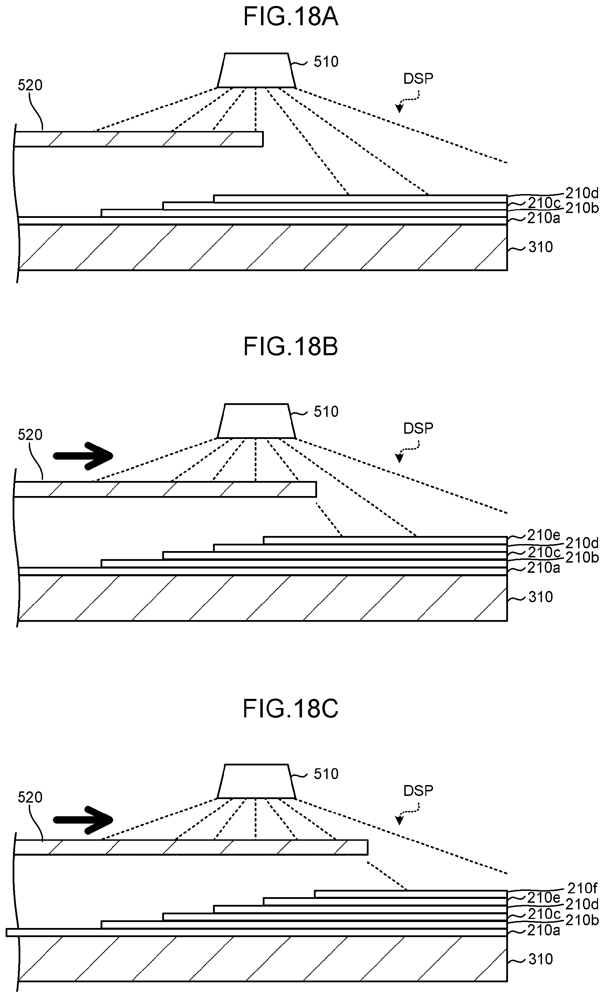

As illustrated in Figs. 18A to 18C, the expansion of the shielded area by the shielding plate 520 and the spraying of the dispersion liquid DSP by the spray 510 are repeated a plurality of times, and the thin layers 210d to 210f are sequentially formed on the support substrate 310.

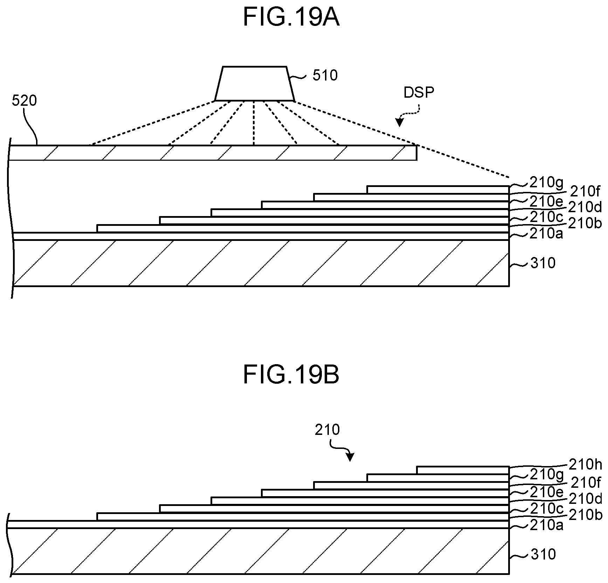

As illustrated in Figs. 19A to 19B, the expansion of the shielded area by the shielding plate 520 and the spraying of the dispersion liquid DSP by the spray 510 are further repeated to sequentially form the thin layers 210g and 210h on the support substrate 310. As a result, the protective layer 210 is formed on the support substrate 310.

Thereafter, the protective layer 210 is applied to the frame 22.

As described above, the pellicle 200 of the second embodiment is manufactured.

According to the method of manufacturing the pellicle 200 of the third modification, the pellicle 200 can be obtained that has the effect similar to that of the above second embodiment.

### (Fourth modification)

In the second embodiment and the first to third modifications described above, changing the thickness of the protective layer 210 of the pellicle 200 has changed the intensity of the reflected light from the photomask 10c to adjust the light intensity in the exposed area Dex subjected to double exposure. However, the approach to adjust the light intensity of the double exposure area by the pellicle is not limited thereto.

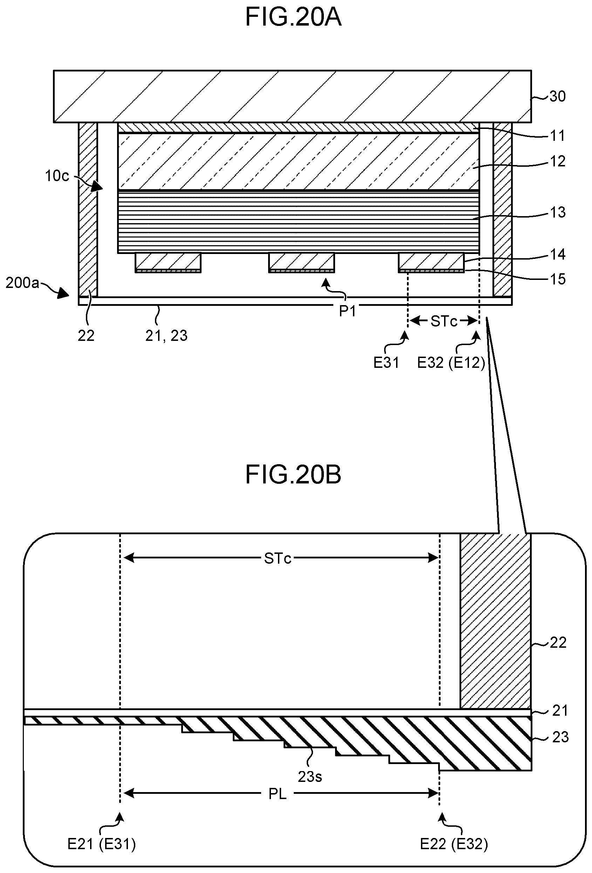

In the following fourth modification, a method of adjusting the light intensity by a pellicle 200a by using an approach different from those of the second embodiment and the first to third modifications will be described with reference to Figs. 20A and 20B.

Figs. 20A and 20B are schematic diagrams each illustrating an exemplary configuration of the photomask 10c according to the fourth modification of the second embodiment. More specifically, Fig. 20A is a cross-sectional view of the photomask 10c with the pellicle 200a mounted thereon, and Fig. 20B is an enlarged cross-sectional view of the pellicle 200a.

As illustrated in Fig. 20A, the pellicle 200a includes the protective layer 21, an oxidation-inhibiting layer 23, and the frame 22.

The oxidation-inhibiting layer 23 is, for example, a SiO₂ layer, a SiN layer, or the like, and is arranged to cover a surface of the protective layer 21 facing the wafer in order to suppress oxidation of the protective layer 21. In addition, the oxidation-inhibiting layer 23 of the fourth modification has a thickness that changes in an area corresponding to the stitching area STc. More specifically, in the area PL of the pellicle 200a, the oxidation-inhibiting layer 23 has a thickness increasing from the end portion E21 corresponding to the end portion E31 of the stitching area STc closer to the center of the photomask 10c toward the end portion E22 corresponding to the other end portion E32 of the stitching area STc located at the end portion E12 of the photomask 10c.

As illustrated in Fig. 20B, the oxidation-inhibiting layer 23 whose thickness changes as described above has a stepped portion 23s having a stair profile.

Similarly to the protective layer 21, the oxidation-inhibiting layer 23 has high transmittance with to exposure light such as EUV, but increasing the thickness of the oxidation-inhibiting layer 23 enables to reduce the transmittance of the exposure light. Therefore, increasing the thickness of the oxidation-inhibiting layer 23 toward the position corresponding to the end portion E12 of the photomask 10c reduces the light intensity of the exposure light reaching the reflective layer 13, enabling reduction of the reflection intensity per unit area of the photomask 10c.

The oxidation-inhibiting layer 23 having a shape as described above is also allowed to be formed by performing formation by CVD or the like and molding by etching or the like.

According to the photomask 10c of the fourth modification, in the area PL included in the pellicle 200a, the oxidation-inhibiting layer 23 included in the pellicle 200a has a thickness increasing from the end portion E21 corresponding to the inner position of the photomask 10c toward the other end portion E22 corresponding to the end portion E12 on the one side of the photomask 10c.

This configuration makes it possible to reduce the light intensity of the exposure light reaching the reflective layer 13 toward the end portion E12 of the photomask 10c to reduce the reflection intensity of the exposure light. Therefore, it is possible to suppress the critical dimension loss caused by double exposure due to overlapping of the exposed areas EX1 and EX2.

In addition, the photomask 10c of the fourth modification has the effects similar to those of the second embodiment described above.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A photomask (10, 10b) including a stitching area (ST, STa, STb) having a first end portion (E32) at one end portion (E12) of the photomask (10, 10b) and having a second end portion (E31) at a position located inward from the one end portion (E12) by a predetermined distance, the photomask (10, 10b) comprising:
a substrate (12);
a reflective layer (13, 13b) that is arranged on a first surface of the substrate (12), the reflective layer (13, 13b) configured to reflect light; and
a light-shielding pattern (P1 P2, P3) that is arranged on a second surface of the reflective layer (13, 13b) opposite to the substrate (12) and includes a light-absorbing layer (15) configured to absorb the light, wherein
in the stitching area (ST, STa, STb), a reflection intensity of the light is lower on a side of the first end portion (E32) than on a side of the second end portion (E31).

2. The photomask (10) according to claim 1, wherein
the light-shielding pattern (P1, P2) includes:
a first light-shielding pattern (P1) that is arranged on the second surface of the reflective layer (13) including the stitching area (ST); and
a second light-shielding pattern (P2) that is arranged in the stitching area (ST) on the second surface of the reflective layer (13), and
a coverage of the second light-shielding pattern (P2) is larger on the side of the first end portion (E32) than on the side of the second end portion (E31) of the stitching area (ST).

3. The photomask (10) according to claim 2, wherein
the coverage of the second light-shielding pattern (P2) increases stepwise from the second end portion (E31) toward the first end portion (E32) of the stitching area (ST).

4. The photomask (10) according to claim 2, wherein
the first light-shielding pattern (P1) is arranged in a region between the one end portion (E12) and the other end portion (E11).

5. The photomask according to claim 1, wherein
the light-shielding pattern (P1, P3) includes:
a first light-shielding pattern (P1) that is arranged on the second surface of the reflective layer (13) including the stitching area (STa); and
a second light-shielding pattern (P3) that is arranged in the stitching area (STa) on the second surface of the reflective layer (13), wherein
in the second light-shielding pattern (P3), a thickness of the light-absorbing layer (15) is larger on the side of the first end portion (E32) than on the side of the second end portion (E31) of the stitching area (STa).

6. The photomask (10b) according to claim 1, wherein
a thickness of the reflective layer (13b) is smaller on the side of the first end portion (E32) than on the side of the second end portion (E31) of the stitching area (STb).

7. A photomask (10c) comprising:
a substrate (12);
a reflective layer (13) that is arranged on a first surface of the substrate (12), the reflective layer (13) configured to reflect light;
a light-shielding pattern (P1) that is arranged on a second surface of the reflective layer (13) opposite to the substrate (12) and includes a light-absorbing layer (15) configured to absorb the light; and
a pellicle (200, 200a) that is spaced apart from the light-shielding pattern (P1) to face the first surface, wherein
the pellicle (200, 200a) includes:
an area (PL) that has a first end portion (E22) at a position corresponding to one end portion of the substrate (12) and has a second end portion (E21) at a position corresponding to a position located inward from the one end portion of the substrate (12) by a predetermined distance; and
a first layer (210, 23) that thickens from the second end portion (E21) toward the first end portion (E22).

8. The photomask (10c) according to claim 7, wherein
the first layer (210) is a protective layer (210) that protects the light-shielding pattern (P1).

9. The photomask (10c) according to claim 7, wherein
the pellicle (200a) further includes a second layer (21) that covers a third surface of the first layer (23) facing the light-shielding pattern (P3),
the first layer (23) is a SiO₂ or SiN layer, and
the second layer (21) is a protective layer (21) that protects the light-shielding pattern (P1).

10. An exposure method using a photomask according to any one of claims 1 to 6 as a pair of first and second photomasks, the exposure method comprising:
exposing a first area (EX1) extending from one end portion of a shot area (SH) provided on a wafer (100) to a position of the shot area (SH) located inward by a first distance from the one end portion, by using a first photomask (10-1); and
exposing a second area (EX2) extending from the other end portion of the shot area (SH) to a position of the shot area (SH) located inward by a second distance from the other end portion, by using a second photomask (10-2), and exposing the shot area (SH) while a third area (Dex) located at a center portion of the shot area (SH) is subjected to double exposure.

11. An exposure method using a photomask according to any one of claims 7 to 9 as a pair of first and second photomasks, the exposure method comprising:
exposing a first area (EX1) extending from one end portion of a shot area (SH) provided on a wafer (100) to a position of the shot area (SH) located inward by a first distance from the one end portion, by using a first photomask (10-1); and
exposing a second area (EX2) extending from the other end portion of the shot area (SH) to a position of the shot area (SH) located inward by a second distance from the other end portion, by using a second photomask (10-2), and exposing the shot area (SH) while a third area (Dex) located at a center portion of the shot area (SH) is subjected to double exposure.
